# EUROPÄISCHE PATENTSCHRIFT

(11) **EP 3 854 525 B1**
(45) Veröffentlichungstag und Bekanntmachung des Hinweises auf die Patenterteilung: **01.04.2026**
(21) Anmeldenummer: 21150963.3
(22) Anmeldetag: 11.01.2021
(51) Int. Cl.: B24B 37/08, B24B 37/28

(54) **LÄUFERSCHEIBE, DOPPELSEITENBEARBEITUNGSMASCHINE UND VERFAHREN ZUM BEARBEITEN MINDESTENS EINES WERKSTÜCKS IN EINER DOPPELSEITENBEARBEITUNGSMASCHINE**
ROTOR DISC, DOUBLE-SIDED PROCESSING MACHINE AND METHOD FOR PROCESSING AT LEAST ONE WORKPIECE IN A DOUBLE SIDED PROCESSING MACHINE
DISQUE DE ROTOR, MACHINE D'USINAGE DOUBLE FACE ET PROCÉDÉ D'USINAGE D'AU MOINS UNE PIÈCE DANS UNE MACHINE D'USINAGE DOUBLE FACE

(30) Priorität: 21.01.2020 DE 102020101313
(43) Veröffentlichungstag der Anmeldung: 28.07.2021
(73) Patentinhaber: Lapmaster Wolters GmbH, 24768 Rendsburg (DE)
(72) Erfinder: Kanzow, Jörn, 24103 Kiel (DE); Helge, Möller, 24943 Flensburg (DE)
(74) Vertreter: Hauck Patent- und Rechtsanwälte PartmbB

(56) Entgegenhaltungen:
- DE-A1- 102017 221 931
- DE-T5- 112017 005 728
- JP-A- 2013 132 744
- JP-A- 2014 077 163
- JP-A- 2015 111 487

## Beschreibung

Die Erfindung betrifft eine Läuferscheibe zum Führen von Werkstücken in einer Doppelseitenbearbeitungsmaschine, umfassend mindestens eine Werkstücköffnung zur Aufnahme mindestens eines in der Doppelseitenbearbeitungsmaschine beidseitig materialabtragend zu bearbeitenden Werkstücks. Die Erfindung betrifft außerdem eine Doppelseitenbearbeitungsmaschine und ein Verfahren zum Bearbeiten mindestens eines Werkstücks in einer Doppelseitenbearbeitungsmaschine.

Werkstücke, wie beispielsweise Wafer, werden in Doppelseitenbearbeitungsmaschinen, beispielsweise Doppelseitenpoliermaschinen, zur Bearbeitung in Läuferscheiben geführt. Die Läuferscheiben besitzen in der Regel mehrere Werkstücköffnungen, in denen die zu bearbeitenden Werkstücke schwimmend aufgenommen sind. Die Läuferscheiben sind im Betrieb zwischen den Arbeitsscheiben der Doppelseitenbearbeitungsmaschine in dem durch die Arbeitsscheiben gebildeten Arbeitsspalt angeordnet. Im Zuge der Relativdrehung zwischen den Arbeitsscheiben werden die Läuferscheiben einerseits entlang einer Kreisbahn durch den Arbeitsspalt und andererseits um ihre eigene Achse gedreht. Dadurch bewegen sich die in den Läuferscheiben schwimmend gehaltenen Werkstücke entlang zykloider Bahnen durch den Arbeitsspalt. Durch diese Bewegung soll eine möglichst gleichförmige materialabtragende Bearbeitung erfolgen und somit eine besonders hohe Planparallelität und Ebenheit der bearbeiteten Werkstücke erreicht werden. Zur materialabtragenden Bearbeitung wird in der Regel eine Bearbeitungsflüssigkeit, insbesondere eine sogenannte Slurry, in den Arbeitsspalt gegeben. Diese Bearbeitungsflüssigkeit kann abrasive Bestandteile enthalten.

In solchen Doppelseitenbearbeitungsmaschinen bearbeitete Halbleiterwafer werden insbesondere zur Ausbildung integrierter Schaltkreise (IC) verwendet. Da die Strukturen von integrierten Schaltkreisen immer kleiner werden, ist es bei der Herstellung von Halbleiterwafern, zum Beispiel aus Silizium, von entscheidender Bedeutung, dass verschiedene Geometrieparameter bestmöglich eingehalten werden. Insbesondere soll die Dickenstreuung über das gesamte Werkstück minimal sein und die Ebenheit am Rand des Werkstücks maximiert werden. Außerdem soll der Verschleiß der Läuferscheiben minimiert werden.

Bislang eingesetzte Läuferscheiben und Bearbeitungsverfahren führen zu einer nicht unerheblichen Verrundung der Werkstücke im Rand- bzw. Kantenbereich. Außerdem unterliegen gängige Läuferscheiben einem erheblichen Verschleiß. In DE 10 2017 221931 A1 wird zur Erhöhung der Verschleißfestigkeit und zur Verbesserung der Randgeometrie eine Läuferscheibe mit einer DLC-Beschichtung (Diamond-Like-Carbon) und einer hydrophilen Oberfläche mit einem Kontaktwinkel eines Wassertropfens von weniger als 25° vorgeschlagen. Diese Maßnahmen führen in der Praxis jedoch nicht zu einer ausreichenden Erhöhung der Verschleißfestigkeit und einer ausreichend verbesserten Randgeometrie der Werkstücke.

Aus DE 11 2017 005 728 T5 ist ein Träger für eine doppelseitige Poliervorrichtung bekannt, der aus einem Harz besteht, wobei ein durchschnittlicher Kontaktwinkel mit Polierpads in Kontakt kommenden Vorder- und Rückflächen des Trägers mit reinem Wasser von 45° oder mehr und 60° oder weniger beträgt, und wobei ein Unterschied der durchschnittlichen Kontaktwinkel zwischen der Vorder- und der Rückfläche 5° oder weniger beträgt. Hierdurch soll die Polierrate für einen Wafer auch bei Verwendung von Trägern aus Harz gesteigert werden.

Aus JP 2014 077163 A wird vorgeschlagen, Komponenten einer Halbleiterherstellvorrichtung mit einer amorphen Kohlenstoffschicht (Diamond Like Carbon DLC) zu versehen. Auf diese Weise soll die Verschleißfestigkeit der Komponenten verbessert werden.

JP 2013 132744 A beschreibt einen Polierträger und ein Verfahren zum Polieren eines Glassubstrats für ein magnetisches Aufnahmemedium sowie ein Herstellerverfahren für ein Glassubstrat für ein magnetisches Aufnahmemedium. Zum Adressieren des Problems eines Anhaftens einer Oberseite eines Polierträgers an einem Polierpad des Polierprozesses ist vorgesehen, dass sich die Kontaktwinkel einer Oberseite und einer Unterseite des Polierträgers um 10° oder mehr unterscheiden. Vorzugsweise ist der Unterschied zwischen den Kontaktwinkeln der Ober- und Unterseite des Polierträgers 15° oder mehr, und weiter vorzugsweise 20° oder mehr. Indem insbesondere die Oberseite des Trägers einen größeren Kontaktwinkel mit Wasser aufweist, soll das unerwünschte Anhaften mit dem Polierpad vermieden werden.

JP 2015 111487 A beschreibt ein Verfahren zur Herstellung eines Glassubstrats, bei dem ein Polierpad und eine Polierlösung mit einem Kontaktwinkel von 50° oder weniger eingesetzt werden.

Ausgehend von dem erläuterten Stand der Technik liegt der Erfindung daher die Aufgabe zugrunde, eine Läuferscheibe, eine Doppelseitenbearbeitungsmaschine und ein Verfahren der eingangs genannten Art bereitzustellen, mit denen insbesondere die Randgeometrie der Werkstücke weiter optimiert und der Verschleiß der Läuferscheiben weiter reduziert werden kann.

Die Erfindung löst die Aufgabe durch die Gegenstände der Ansprüche 1, 5 und 6. Vorteilhafte Ausgestaltungen finden sich in den abhängigen Ansprüchen, der Beschreibung und den Figuren.

Für eine Läuferscheibe der eingangs genannten Art löst die Erfindung die Aufgabe dadurch, dass die Oberfläche der Läuferscheibe einen Kontaktwinkel eines Wassertropfens von mindestens 70° und nicht mehr als 75° aufweist.

Die Erfindung löst die Aufgabe außerdem durch eine Doppelseitenbearbeitungsmaschine, umfassend eine erste Arbeitsscheibe mit einer ersten Arbeitsfläche und eine zweite Arbeitsscheibe mit einer zweiten Arbeitsfläche, wobei die Arbeitsflächen zwischen sich einen Arbeitsspalt begrenzen, und wobei mindestens eine der Arbeitsscheiben der Doppelseitenbearbeitungsmaschine drehend antreibbar ist, weiter umfassend eine Flüssigkeitszuführung zur Zuführung einer Bearbeitungsflüssigkeit in den Arbeitsspalt, und umfassend mindestens eine erfindungsgemäße Läuferscheiben, mit der mindestens ein Werkstück in dem Arbeitsspalt zur beidseitig materialabtragenden Bearbeitung geführt werden kann.

Außerdem löst die Erfindung die Aufgabe durch ein Verfahren zum Bearbeiten mindestens eines Werkstücks in einer erfindungsgemäßen Doppelseitenbearbeitungsmaschine, bei dem das mindestens eine Werkstück in der mindestens einen Werkstücköffnung der mindestens einen Läuferscheibe aufgenommen und zur Bearbeitung in dem Arbeitsspalt der Doppelseitenbearbeitungsmaschine geführt wird, wobei mindestens eine der Arbeitsscheiben der Doppelseitenbearbeitungsmaschine drehend angetrieben wird, und wobei während der Bearbeitung eine Bearbeitungsflüssigkeit in den Arbeitsspalt zugeführt wird.

Bei der Doppelseitenbearbeitungsmaschine kann es sich beispielsweise um eine Doppelseitenpoliermaschine handeln. Eine Läuferscheibe umfasst dabei üblicherweise mehrere Werkstücköffnungen. Wie eingangs erläutert, werden Werkstücke, wie Wafer, insbesondere Halbleiterwafer, zum Beispiel aus Silizium, schwimmend in Werkstücköffnungen von Läuferscheiben gehalten. Die Läuferscheiben werden im Betrieb in dem Arbeitsspalt zwischen den gegenüberliegenden Arbeitsscheiben der Doppelseitenbearbeitungsmaschine angeordnet. In der Regel besitzen die Läuferscheiben eine Außenverzahnung, die mit einer am inneren Rand des Arbeitsspalts vorgesehenen Innenverzahnung und mit einer am äußeren Rand der Arbeitsscheibe vorgesehenen Außenverzahnung der Doppelseitenbearbeitungsmaschine, beispielsweise der unteren Arbeitsscheibe, in Eingriff steht. Im Zuge der im Betrieb erfolgenden Drehung mindestens einer Arbeitsscheibe wird die Läuferscheibe dadurch einerseits entlang einer Kreisbahn durch den Arbeitsspalt und andererseits um ihre eigene Achse gedreht. Die in den Werkstücköffnungen der Läuferscheiben aufgenommenen Werkstücke werden dadurch in an sich bekannter Weise entlang zykloider Bahnen durch das Werkstück geführt und materialabtragend bearbeitet. Ebenfalls in an sich bekannter Weise wird während der Bearbeitung eine Bearbeitungsflüssigkeit, zum Beispiel eine sogenannte Slurry, in den Arbeitsspalt gegeben. Die Bearbeitungsflüssigkeit kann abrasive Elemente enthalten.

Erfindungsgemäß weist die Oberfläche der Läuferscheibe einen Kontaktwinkel eines Wassertropfens von mindestens 70° auf. Die Oberfläche ist also im Gegensatz zu dem eingangs erläuterten Stand der Technik nicht hydrophil. Die Erfinder haben erkannt, dass im Stand der Technik eine nicht optimale Verteilung der Bearbeitungsflüssigkeit auf der Oberfläche der Läuferscheibe und damit auf den bearbeiteten Werkstücken zu einem erhöhten Verschleiß der Läuferscheibe und einer nicht optimalen Randgeometrie der bearbeiteten Werkstücke führt. Insbesondere haben die vorliegenden Erfinder erkannt, dass im Stand der Technik ein inhomogener Flüssigkeitsfilm zwischen dem bearbeiteten Werkstück und der Oberfläche der Arbeitsscheiben, beispielsweise einem Poliertuch, auftritt, insbesondere eine Abnahme der Dicke des Flüssigkeitsfilms vom Rand zur Mitte des bearbeiteten Werkstücks, sodass ein ungleichmäßiger Materialabtrag erfolgt, was wiederum zu der unerwünschten verstärkten

Randverrundung des Werkstücks führt. Dem wird durch die erfindungsgemäße Oberflächengestaltung der Läuferscheibe entgegengewirkt. Durch die erfindungsgemäße Ausgestaltung der Oberfläche der Läuferscheibe wird ein im Vergleich zum Stand der Technik homogenerer Flüssigkeitsfilm auf der Läuferscheibe und damit auch auf dem bearbeiteten Werkstück erreicht. Insbesondere wird durch die erfindungsgemäße Ausgestaltung der Läuferscheibenoberfläche der Transport der Bearbeitungsflüssigkeit, insbesondere der Polierflüssigkeit, zur Werkstückmitte hin erheblich verbessert. Auf diese Weise wird eine im Stand der Technik auftretende unerwünschte Randverrundung des Werkstücks minimiert. Insgesamt wird so die Geometrie der bearbeiteten Werkstücke verbessert. Gleichzeitig minimiert die erfindungsgemäße Homogenisierung des Flüssigkeitsfilms den Verschleiß der Läuferscheiben und verlängert die Lebenszeit und führt zu entsprechenden Kostenvorteilen. Die vorliegenden Erfinder haben erkannt, dass zu diesem Zweck gerade keine hydrophile Oberfläche, wie noch in DE 10 2017 221931 A1 vorgeschlagen, zielführend ist, sondern im Gegenteil eine nicht-hydrophile bzw. sogar hydrophobe Oberfläche. Die erfindungsgemäße Läuferscheibe kann zum Beispiel aus einem metallischen Werkstoff, wie zum Beispiel Edelstahl, bestehen.

Erfindungsgemäß weist die Oberfläche der Läuferscheibe einen Kontaktwinkel eines Wassertropfens von nicht mehr als 75° auf. Die Erfinder haben weiter erkannt, dass es insbesondere oberhalb von 90° wieder zu einer verstärkten Randverrundung des Werkstücks kommt. Es existiert also ein optimales Fenster für den Kontaktwinkel, in dem die Randverrundung minimiert ist.

Gemäß einer weiteren Ausgestaltung kann der erfindungsgemäß gewünschte Kontaktwinkel der Oberfläche erlangt werden, indem die Oberfläche der Läuferscheibe aufgeraut ist. Die Einstellung des gewünschten Kontaktwinkels erfolgt dann also mechanisch, zum Beispiel durch einen entsprechenden Doppelseitenbearbeitungsprozess für die Läuferscheiben. Entsprechend aufgeraute Läuferscheiben können dann ohne weitere Beschichtung bleiben. Als Material für die aufgerauten Läuferscheiben kommt insbesondere ein metallischer Werkstoff, zum Beispiel Edelstahl, in Frage.

Es ist auch möglich, die Oberfläche mit dem gewünschten Kontaktwinkel durch eine geeignete Auswahl des Läuferscheibenmaterials zu erreichen, gegebenenfalls ohne zusätzliche Beschichtung oder aufrauende Maßnahmen. Als Läuferscheibenmaterial kommt zum Beispiel ein metallischer Werkstoff, wie zum Beispiel Edelstahl, in Frage.

Auch ist es möglich, den gewünschten Kontaktwinkel der Oberfläche durch eine geeignete Beschichtung eines Läuferscheibengrundmaterials zu erreichen. Beispielsweise ist es durch eine geeignete DLC-Beschichtung möglich, den erfindungsgemäßen Kontaktwinkel einzustellen, wobei dann eine weitere Bearbeitung, wie ein Aufrauen, nicht erfolgen muss. Als Läuferscheibengrundmaterial kann zum Beispiel ein Metall, wie zum Beispiel Edelstahl, zum Einsatz kommen.

Nach einer weiteren Ausgestaltung kann die Läuferscheibe neben der mindestens einen Werkstücköffnung mindestens eine Hilfsöffnung aufweisen, in der sich während einer Bearbeitung des mindestens einen Werkstücks in der Doppelseitenbearbeitungsmaschine eine Bearbeitungsflüssigkeit sammeln kann, vorzugsweise eine Polierflüssigkeit, wie eine Slurry. Die Läuferscheibe kann insbesondere mehrere Werkstücköffnungen und/oder mehrere Hilfsöffnungen aufweisen. Durch das gezielte Vorsehen einer oder mehrerer Hilfsöffnungen kann der erfindungsgemäße Effekt der Homogenisierung des Bearbeitungsflüssigkeitsfilms weiter verstärkt werden. Es hat sich gezeigt, dass in den Hilfsöffnungen befindliche Bearbeitungsflüssigkeit den Flüssigkeitsfilm über die gesamte Oberfläche der Läuferscheibe und damit auch über die Oberfläche des bearbeiteten Werkstücks vergleichmäßigt. Einerseits wird durch die Hilfsöffnungen, in denen im Betrieb kein zu bearbeitendes Werkstück aufgenommen wird, eine gleichmäßigere Flüssigkeitsverteilung auf der Ober- und Unterseite der Läuferscheibe erreicht, da die Bearbeitungsflüssigkeit durch die Hilfsöffnungen relativ frei hindurchtreten kann. Andererseits wird durch die Hilfsöffnungen der Flüssigkeitstransport von dem Außenbereich der Läuferscheiben, insbesondere dem Bereich einer Außenverzahnung, zu den Werkstücken und zur Mitte der Läuferscheibe verbessert. Auf diese Weise kann das Bearbeitungsergebnis weiter optimiert und der Verschleiß der Läuferscheiben weiter minimiert werden. Die Hilfsöffnungen können insbesondere zwischen den Werkstücköffnungen ausgebildet sein. Beispielsweise können jeweils mehrere Hilfsöffnungen zwischen zwei benachbarten Werkstücköffnungen ausgebildet sein. Die Flüssigkeitsverteilung wird hierdurch weiter verbessert.

Ausführungsbeispiele der Erfindung werden nachfolgend anhand von Figuren näher erläutert. Es zeigen schematisch:
- Figur 1: eine erfindungsgemäße Doppelseitenbearbeitungsmaschine in einer Schnittansicht,
- Figur 2: eine erfindungsgemäße Läuferscheibe nach einem ersten Ausführungsbeispiel in einer Draufsicht,
- Figur 3: eine erfindungsgemäße Läuferscheibe nach einem weiteren Ausführungsbeispiel in einer Draufsicht, und
- Figur 4: ein Diagramm mit durchschnittlichen Dickenprofilen unterschiedlicher doppelseitig materialabtragend bearbeiteter Werkstücke.

Soweit nichts anderes angegeben ist, bezeichnen in den Figuren gleiche Bezugszeichen gleiche Gegenstände.

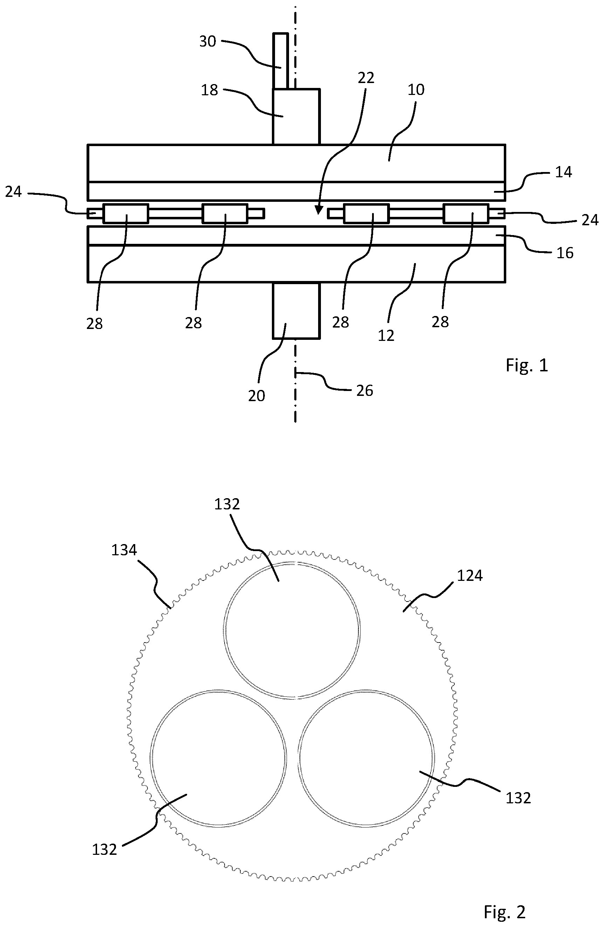

In Figur 1 ist eine erfindungsgemäße Doppelseitenbearbeitungsmaschine, insbesondere eine Doppelseitenpoliermaschine, äußerst schematisch dargestellt. Die Doppelseitenbearbeitungsmaschine weist eine obere Trägerscheibe 10 und eine dieser gegenüberliegend angeordnete untere Trägerscheibe 12 auf. Die obere Trägerscheibe 10 trägt eine obere Arbeitsscheibe 14 und die untere Trägerscheibe 12 trägt eine untere Arbeitsscheibe 16. Die Arbeitsscheiben 14, 16 können zum Beispiel mit einem Polierbelag, insbesondere einem Polierpad, versehen sein. Über Antriebswellen 18, 20 können die Trägerscheiben 10, 12 und mit ihnen die Arbeitsscheiben 14, 16 drehend um ihre in Figur 1 vertikal verlaufende Achse 26 angetrieben werden, im Betrieb der Doppelseitenbearbeitungsmaschine insbesondere gegenläufig.

Die Arbeitsscheiben 14, 16 begrenzen zwischen sich einen Arbeitsspalt 22. In dem Arbeitsspalt sind mehrere Läuferscheiben 24 angeordnet. In Figur 1 sind zwei Läuferscheiben 24 dargestellt. Selbstverständlich können auch mehr oder weniger als zwei Läuferscheiben vorgesehen sein. In den Werkstücköffnungen der Läuferscheiben 24 sind in dem Arbeitsspalt 22 beidseitig materialabtragend zu bearbeitende Werkstücke 28, beispielsweise Halbleiterwafer, beispielsweise aus Silizium, schwimmend gehalten. Die Läuferscheiben 24 besitzen üblicherweise an ihrem äußeren Rand eine in Figur 1 nicht näher dargestellte Außenverzahnung, die in Eingriff steht mit einer am inneren Rand des Arbeitsspalts 22 angeordneten, in Figur 1 nicht näher dargestellten Innenverzahnung sowie einer am äußeren Rand des Arbeitsspalts 22 angeordneten, in Figur 1 ebenfalls nicht näher dargestellten Außenverzahnung. Dadurch werden die Läuferscheiben 24 im Betrieb entlang einer Kreisbahn durch den Arbeitsspalt 22 und zusätzlich um ihre Achsen gedreht, sodass sich die Werkstücke 28 entlang zykloider Bahnen durch den Arbeitsspalt 22 bewegen. Mittels einer in Figur 1 schematisch bei dem Bezugszeichen 30 dargestellten Flüssigkeitszuführung wird im Betrieb eine Bearbeitungsflüssigkeit, insbesondere eine Polierflüssigkeit (Slurry) in den Arbeitsspalt 22 zugeführt. Die Oberfläche der Läuferscheiben 24 besitzt einen Kontaktwinkel eines Wassertropfens von mindestens 70° und nicht mehr als 75°. Beispielsweise kann die Oberfläche der Läuferscheibe 24 mechanisch aufgeraut sein um diesen Kontaktwinkel zu erreichen. Auch kann die Oberfläche der Läuferscheibe 24, die zum Beispiel aus Edelstahl bestehen kann, alternativ oder zusätzlich zu einem Aufrauen mit einer Beschichtung versehen sein, beispielsweise einer DLC-Beschichtung, um den gewünschten Kontaktwinkel zu erreichen.

In Figur 2 ist eine weitere erfindungsgemäße Läuferscheibe 124 gezeigt, die in der in Figur 1 gezeigten Doppelseitenbearbeitungsmaschine zum Einsatz kommen kann. Die Läuferscheibe 124 besitzt in dem gezeigten Beispiel drei kreisrunde Werkstücköffnungen 132, in denen Werkstücke zur Bearbeitung schwimmend aufgenommen werden können. Außerdem ist bei der Läuferscheibe 124 in Figur 2 die Außenverzahnung 134 zu erkennen. Auch die in Figur 2 gezeigte Läuferscheibe 124 besitzt einen Kontaktwinkel eines Wassertropfens von mindestens 70° und nicht mehr als 75°. Beispielsweise kann die Oberfläche der Läuferscheibe 124 mechanisch aufgeraut sein um diesen Kontaktwinkel zu erreichen. Auch kann die Oberfläche der Läuferscheibe 124, die zum Beispiel aus Edelstahl bestehen kann, alternativ oder zusätzlich zu einem Aufrauen mit einer Beschichtung versehen sein, beispielsweise einer DLC-Beschichtung, um den gewünschten Kontaktwinkel zu erreichen.

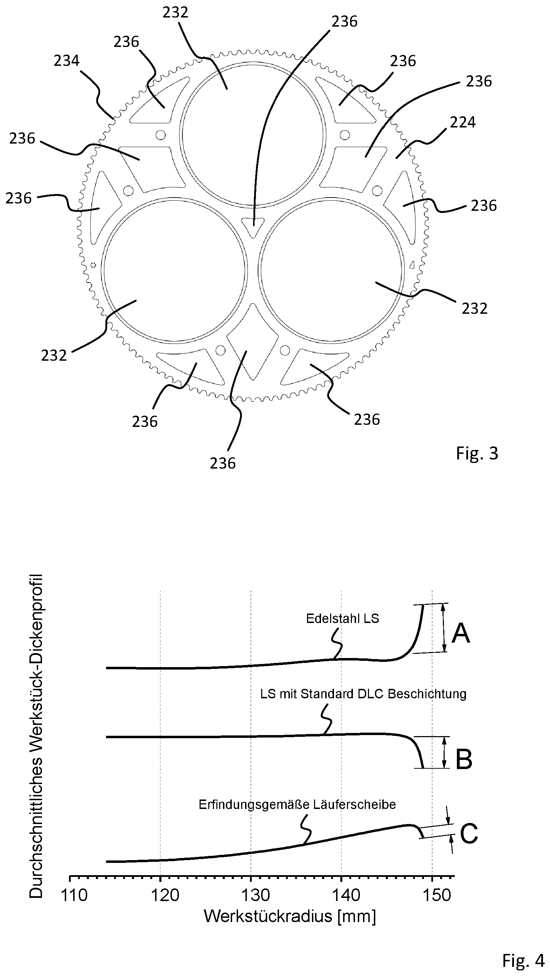

Figur 3 zeigt ein weiteres Ausführungsbeispiel einer Läuferscheibe 224, die ebenfalls in der in Figur 1 gezeigten Doppelseitenbearbeitungsmaschine zum Einsatz kommen kann. Sie besitzt wiederum drei kreisrunde Werkstücköffnungen 232 zur schwimmenden Aufnahme von zu bearbeitenden Werkstücken sowie eine

Außenverzahnung 234. Im Unterschied zu der in Figur 2 gezeigten Läuferscheibe 124 besitzt die in Figur 3 gezeigte Läuferscheibe 224 zusätzlich zu den drei Werkstücköffnungen 232 mehrere Hilfsöffnungen 236. In den Hilfsöffnungen 236 kann sich während der Bearbeitung der Werkstücke in dem Arbeitsspalt 22 der Doppelseitenbearbeitungsmaschine die zugeführte Bearbeitungsflüssigkeit sammeln. Die Hilfsöffnungen 236 dienen als Reservoir für Bearbeitungsflüssigkeit und führen zu einer optimalen Homogenisierung des Flüssigkeitsfilms auf der Läuferscheibe 224, und zwar auf der Ober- und Unterseite und auf den einzelnen Seiten, und damit auch auf den in den Werkstücköffnungen 232 aufgenommenen Werkstücken. Auch die in Figur 3 gezeigte Läuferscheibe 224 besitzt einen Kontaktwinkel eines Wassertropfens von mindestens 70° und nicht mehr als 75°. Beispielsweise kann die Oberfläche der Läuferscheibe 224 mechanisch aufgeraut sein um diesen Kontaktwinkel zu erreichen. Auch kann die Oberfläche der Läuferscheibe 224, die zum Beispiel aus Edelstahl bestehen kann, alternativ oder zusätzlich zu einem Aufrauen mit einer Beschichtung versehen sein, beispielsweise einer DLC-Beschichtung, um den gewünschten Kontaktwinkel zu erreichen.

Sämtliche der in den Figuren 1-3 gezeigten Läuferscheiben 24, 124, 224 weisen einen Kontaktwinkel eines Wassertropfens von nicht mehr als 75° auf. Außerdem weisen sie einen Kontaktwinkel eines Wassertropfens von mindestens 70° auf. Sie können beispielsweise aus Edelstahl bestehen bzw. bei einer nachfolgenden Beschichtung Edelstahl als Grundmaterial aufweisen. Sie können aber auch aus anderen Materialien bestehen. Auch ist es denkbar, dass die Läuferscheiben 24, 124, 224 aus einem Material bestehen, das bereits intrinsisch den gewünschten Kontaktwinkel besitzt, sodass keine anschließende Beschichtung oder Aufrauung erforderlich ist. Sofern die Oberfläche der Läuferscheiben 24, 124, 224 aufgeraut ist, oder sofern das Läuferscheibenmaterial bereits intrinsisch den gewünschten Kontaktwinkel besitzt, ist es möglich, dass diese keine weitere Beschichtung besitzen.

In Figur 4 ist ein durchschnittliches Werkstückdickenprofil für mit drei unterschiedlichen Läuferscheiben bearbeitete Werkstücke, insbesondere Siliziumwafer, dargestellt. Gezeigt ist der äußere Werkstückbereich ab einem Werkstückradius von etwa 114 mm bis zum äußeren Werkstückrand bei etwa 149 mm. Die Grunddicke insbesondere im Bereich der Werkstückmitte, in Figur 4 etwa bei dem Werkstücke Radius 114 mm zu erkennen, kann für alle Werkstücke im Wesentlichen gleich sein bzw. normiert sein. Die Kurven sind in Figur 4 lediglich zur Veranschaulichung übereinander dargestellt. Die durchschnittlichen Werkstückdickenprofile wurden durch Bearbeitung jeweils einer Mehrzahl von Werkstücken mit einer der drei Läuferscheiben und anschließender Mittelung des Dickenprofils ermittelt. Die Bearbeitung erfolgte im gezeigten Beispiel in einer Doppelseitenpoliermaschine der Anmelderin, wobei während der Bearbeitung eine Polierflüssigkeit (Slurry) in den Arbeitsspalt zugeführt wurde.

Die in Figur 4 oberste Kurve zeigt das durchschnittliche Werkstückdickenprofil, wobei eine einfache unbeschichtete Edelstahlläuferscheibe verwendet wurde. Die in Figur 4 mittlere Kurve zeigt das durchschnittliche Werkstückdickenprofil, wobei eine Edelstahlläuferscheibe mit einer üblichen DLC-Beschichtung verwendet wurde. Die in Figur 4 unterste Kurve zeigt das durchschnittliche Werkstückdickenprofil unter Verwendung einer erfindungsgemäßen Läuferscheibe mit einem Kontaktwinkel der Oberfläche für einen Wassertropfen von mindestens 70°.

In Figur 4 bei den Buchstaben A, B und C ist jeweils die Höhe der Randverrundung der Werkstückdickenprofile eingezeichnet. Dabei ist gut zu erkennen, dass bei Verwendung der Edelstahlläuferscheibe die Randverrundung A am größten ist, gefolgt von der Randverrundung B bei Verwendung einer Läuferscheibe mit einer üblichen DLC-Beschichtung. Mit der erfindungsgemäßen Läuferscheibe wird dagegen eine erheblich geringere Randverrundung C erzielt.

### Bezugszeichenliste

| | |
|---|---|
| Obere Trägerscheibe | 10 |
| Untere Trägerscheibe | 12 |
| Obere Arbeitsscheibe | 14 |
| Untere Arbeitsscheibe | 16 |
| Antriebswelle | 18 |
| Antriebswelle | 20 |
| Arbeitsspalt | 22 |
| Läuferscheibe | 24 |
| Achse | 26 |
| Werkstück | 28 |
| Flüssigkeitszuführeinrichtung | 30 |
| Läuferscheibe | 124 |
| Werkstücköffnung | 132 |
| Außenverzahnung | 134 |
| Läuferscheibe | 224 |
| Werkstücköffnung | 232 |
| Außenverzahnung | 234 |
| Hilfsöffnung | 236 |

## Patentansprüche

1. Läuferscheibe zum Führen von Werkstücken (28) in einer Doppelseitenbearbeitungsmaschine, umfassend mindestens eine Werkstücköffnung (132, 232) zur Aufnahme mindestens eines in der Doppelseitenbearbeitungsmaschine beidseitig materialabtragend zu bearbeitenden Werkstücks (28), **dadurch gekennzeichnet, dass** die Oberfläche der Läuferscheibe (24, 124, 224) einen Kontaktwinkel eines Wassertropfens von mindestens 70° und nicht mehr als 75° aufweist.

2. Läuferscheibe nach einem der vorhergehenden Ansprüche, **dadurch gekennzeichnet, dass** die Oberfläche der Läuferscheibe (24, 124, 224) aufgeraut ist.

3. Läuferscheibe nach einem der vorhergehenden Ansprüche, **dadurch gekennzeichnet, dass** die Oberfläche der Läuferscheibe (24, 124, 224) beschichtet ist.

4. Läuferscheibe nach Anspruch 3, **dadurch gekennzeichnet, dass** die Beschichtung eine DLC-Beschichtung ist.

5. Doppelseitenbearbeitungsmaschine, umfassend eine erste Arbeitsscheibe (14) mit einer ersten Arbeitsfläche und eine zweite Arbeitsscheibe (16) mit einer zweiten Arbeitsfläche, wobei die Arbeitsflächen zwischen sich einen Arbeitsspalt (22) begrenzen, und wobei mindestens eine der Arbeitsscheiben (14, 16) der Doppelseitenbearbeitungsmaschine drehend antreibbar ist, weiter umfassend eine Flüssigkeitszuführung (30) zur Zuführung einer Bearbeitungsflüssigkeit in den Arbeitsspalt (22), und umfassend mindestens eine Läuferscheibe (24, 124, 224) nach einem der vorhergehenden Ansprüche, mit der mindestens ein Werkstück (28) in dem Arbeitsspalt (22) zur beidseitig materialabtragenden Bearbeitung geführt werden kann.

6. Verfahren zum Bearbeiten mindestens eines Werkstücks (28) in einer Doppelseitenbearbeitungsmaschine nach Anspruch 5, bei dem das mindestens eine Werkstück (28) in der mindestens einen Werkstücköffnung (32, 132, 232) der mindestens einen Läuferscheibe (24, 124, 224) aufgenommen und zur Bearbeitung in dem Arbeitsspalt (22) der Doppelseitenbearbeitungsmaschine geführt wird, wobei mindestens eine der Arbeitsscheiben (14, 16) der Doppelseitenbearbeitungsmaschine drehend angetrieben wird, und wobei während der Bearbeitung eine Bearbeitungsflüssigkeit in den Arbeitsspalt (22) zugeführt wird.

## Claims

1. Rotor disc for guiding workpieces (28) in a double-sided processing machine, comprising at least one workpiece opening (132, 232) for receiving at least one workpiece (28) to be processed by material removal on both sides in the double-sided processing machine, **characterized in that** the surface of the rotor disc (24, 124, 224) has a contact angle of a water drop of at least 70° and not more than 75°.

2. Rotor disc according to any of the preceding claims, **characterized in that** the surface of the rotor disc (24, 124, 224) is roughened.

3. Rotor disc according to any of the preceding claims, **characterized in that** the surface of the rotor disc (24, 124, 224) is coated.

4. Rotor disc according to claim 3, **characterized in that** the coating is a DLC coating.

5. Double-sided processing machine, comprising a first working disc (14) with a first working surface and a second working disc (16) with a second working surface, wherein the working surfaces define a working gap (22) between them, and wherein at least one of the working discs (14, 16) of the double-sided processing machine is rotatably drivable, further comprising a liquid supply (30) for supplying a processing liquid into the working gap (22), and comprising at least one rotor disc (24, 124, 224) according to any of the preceding claims, with which at least one workpiece (28) can be guided in the working gap (22) for material-removing processing on both sides.

6. Method for processing at least one workpiece (28) in a double-sided processing machine according to claim 5, in which the at least one workpiece (28) is received in the at least one workpiece opening (32, 132, 232) of the at least one rotor disc (24, 124, 224) and is guided for processing in the working gap (22) of the double-sided processing machine, wherein at least one of the working discs (14, 16) of the double-sided processing machine is rotatably driven, and wherein a processing liquid is supplied into the working gap (22) during the processing.

## Revendications

1. Disque de rotor pour le guidage de pièces (28) dans une machine d'usinage double face, comportant au moins une ouverture de pièces (132, 232) pour la réception d'au moins une pièce (28) à usiner par enlèvement de matière bilatéral dans la machine d'usinage double face, **caractérisé en ce que** la surface du disque de rotor (24, 124, 224) présente un angle de contact d'au moins 70° et pas supérieur à 75° d'une goutte d'eau.

2. Disque de rotor selon l'une des revendications précédentes, **caractérisé en ce que** la surface du disque de rotor (24, 124, 224) est rendue rugueuse.

3. Disque de rotor selon l'une des revendications précédentes, **caractérisé en ce que** la surface du disque de rotor (24, 124, 224) est revêtue.

4. Disque de rotor selon la revendication 3, **caractérisé en ce que** le revêtement est un revêtement DLC.

5. Machine d'usinage double face, comportant un premier disque de travail (14) doté d'une première surface de travail et un deuxième disque de travail (16) doté d'une deuxième surface de travail, dans laquelle les surfaces de travail délimitent une fente de travail (22) entre elles, et dans laquelle l'un au moins des disques de travail (14, 16) de la machine d'usinage double face peut être entraîné en rotation, comportant en outre une alimentation en fluide (30) pour l'alimentation d'un fluide de travail vers la fente de travail (22), et comportant au moins un disque de rotor (24, 124, 224) selon l'une des revendications précédentes, avec lequel au moins une pièce (28) dans la fente de travail (22) peut être guidée en vue de l'usinage par enlèvement de matière bilatéral.

6. Procédé d'usinage d'au moins une pièce (28) dans une machine d'usinage double face selon la revendication 5, dans lequel l'au moins une pièce (28) est reçue dans l'au moins une ouverture de pièces (32, 132, 232) de l'au moins un disque de rotor (24, 124, 224) et guidée en vue de l'usinage dans la fente de travail (22) de la machine d'usinage double face, dans lequel au moins l'un des disques de travail (14, 16) de la machine d'usinage double face est entraîné en rotation, et dans lequel un fluide de travail est alimenté vers la fente de travail (22) pendant l'usinage.
